# EUROPEAN PATENT SPECIFICATION

(11) **EP 3 537 859 B1**
(45) Date of publication and mention of the grant of the patent: **14.02.2024**
(21) Application number: 16923852.4
(22) Date of filing: 13.12.2016
(51) Int. Cl.: H05K 7/20

(54) **DEVICE, APPARATUS AND METHOD FOR MONITORING HEAT DISSIPATION STATES OF DEVICES**
VORRICHTUNG, EINRICHTUNG UND VERFAHREN ZUR ÜBERWACHUNG DER WÄRMEABLEITZUSTÄNDE VON VORRICHTUNGEN
DISPOSITIF, APPAREIL ET PROCÉDÉ DE SURVEILLANCE D'ÉTATS DE DISSIPATION DE CHALEUR DE DISPOSITIFS

(43) Date of publication of application: 11.09.2019
(73) Proprietor: Huawei Technologies Co., Ltd., Longgang Shenzhen, Guangdong 518129 (CN)
(72) Inventor: DOU, Quanliang, Shenzhen Guangdong 518129 (CN)
(74) Representative: Epping - Hermann - Fischer
(86) International application number: PCT/CN2016/109621
(87) International publication number: WO 2018/107353

(56) References cited:
- CN-A- 1 470 866
- CN-A- 101 252 821
- CN-A- 102 841 661
- CN-A- 104 712 503
- CN-U- 201 652 690
- CN-U- 203 327 462
- CN-Y- 2 838 216
- US-A1- 2009 034 187
- US-A1- 2010 017 151
- US-A1- 2013 127 313
- US-A1- 2014 147 282

## Description

### TECHNICAL FIELD

Embodiments of this application relate to the field of electronic devices, and more specifically, to an elecronic device, and a method for monitoring a heat dissipation status of the electronic device.

### BACKGROUND

Usually, there is a high-power component in an electronic instrument device, and the high-power component generates a large amount of heat while working. An air outlet and a fan are usually disposed on a frame of the device, to increase a speed of air flow on an internal component and dissipate the heat by cooling the air.

When an speed of air flow inside the device does not meet a design requirement, temperature inside the device is higher than a designed value. Consequently, the device works abnormally, and the device even burns up in a worse case.

Therefore, a device, an apparatus, and a method for monitoring a heat dissipation status of the device need to be provided, to effectively monitor the heat dissipation status of the device.

Document US 2010/0017151 A1 refers to detecting a fouled air filter in a computer equipment enclosure that includes an air filter, to a supply plenum connecting the air filter and the computer equipment enclosure, to a fan operating at a current fan speed, and to a filter monitoring module connected for data communications to a management module. Detecting a fouled air filter includes calculating, by the filter monitoring module, a pressure differential across the air filter; determining, for the current fan speed by the filter monitoring module in dependence upon a pressure differential profile for the air filter, whether the calculated pressure differential across the air filter exceeds a predetermined threshold value; and if the calculated pressure differential across the air filter exceeds the predetermined threshold value, reporting, by the filter monitoring module to the management module, that the calculated pressure differential across the air filter exceeds the predetermined threshold value.

Document US 2013/0127313 A1 provides a housing that holds a plurality of insertion components includes a plurality of insertion positions that hold the plurality of insertion components in a first area of the rack housing adjacent to a first housing side, a reduced pressure shaft in a second area of the rack housing adjacent to the first area, wherein between the reduced pressure shaft and the insertion components, first openings are provided to thereby remove air heated by the insertion components into the reduced pressure shaft, at least two second openings that suction off heated air from the reduced pressure shaft, and at least two non-return arrangements located in the reduced pressure shaft and correlated to the two second openings, the non-return arrangements preventing entry of air through the correlated second opening if no air is suctioned off through this second opening.

### SUMMARY

This application provides an electronic device, and a method for monitoring a heat dissipation status of the electronic device, to effectively monitor the heat dissipation status of the device. The present invention is defined by the attached set of claims. Embodiments and aspects which are not covered by the invention should be considered as examples useful for understanding the invention.

According to a first aspect, a method for monitoring a heat dissipation status of a device is provided, and includes: obtaining first atmospheric pressure on an external surface of the device; obtaining second atmospheric pressure inside the device; and determining, based on a difference between the second atmospheric pressure and the first atmospheric pressure, whether the heat dissipation status of the device is normal.

According to the method for monitoring the heat dissipation status of the device in this application, whether the heat dissipation status of the device is normal is determined based on a difference between atmospheric pressure on the external surface of the device and atmospheric pressure inside the device. In this way, the heat dissipation status of the device can be effectively monitored.

With reference to the first aspect, a heat dissipation fan is disposed inside the device, and the heat dissipation fan has a fan assembly; and the obtaining second atmospheric pressure inside the device includes: obtaining second atmospheric pressure on an air outlet surface of the fan assembly.

In this way, whether the heat dissipation status of the device is normal can be determined more accurately.

With reference to the first aspect, when the heat dissipation fan works in a blowing heat dissipation mode, the determining, based on a difference between the second atmospheric pressure and the first atmospheric pressure, whether the heat dissipation status of the device is normal includes: when it is determined that the difference between the second atmospheric pressure and the first atmospheric pressure is greater than a first preset threshold, determining that the heat dissipation status of the device is normal; or when it is determined that the difference between the second atmospheric pressure and the first atmospheric pressure is less than or equal to a first preset threshold, determining that the heat dissipation status of the device is abnormal.

With reference to the first aspect, when the heat dissipation fan dissipates heat through blowing, the determining, based on a difference between the second atmospheric pressure and the first atmospheric pressure, whether the heat dissipation status of the device is normal includes: when it is determined that the difference between the second atmospheric pressure and the first atmospheric pressure is less than a second preset threshold, determining that the heat dissipation status of the device is normal; or when it is determined that the difference between the second atmospheric pressure and the first atmospheric pressure is greater than or equal to a second preset threshold, determining that the heat dissipation status of the device is abnormal.

With reference to the first aspect, in another implementation of the first aspect, when it is determined that the heat dissipation status of the device is abnormal, the method further includes: obtaining a rotational speed of the heat dissipation fan; and determining, based on a value relationship between the rotational speed of the heat dissipation fan and a preset rotational speed, a reason why the heat dissipation status of the device is abnormal.

With reference to the first aspect and the foregoing implementation of the first aspect, in another implementation of the first aspect, the determining, based on a value relationship between the rotational speed of the heat dissipation fan and a preset rotational speed, a reason why the heat dissipation status of the device is abnormal includes: when it is determined that the rotational speed of the heat dissipation fan is less than the preset rotational speed, determining that the heat dissipation status of the device is abnormal because the heat dissipation fan is faulty; or when it is determined that the rotational speed of the heat dissipation fan is equal to the preset rotational speed, determining that the heat dissipation status of the device is abnormal because an air duct is blocked.

The reason why the heat dissipation status of the device is abnormal is accurately determined based on the value relationship between the rotational speed of the heat dissipation fan and the preset rotational speed, so that a maintenance engineer more quickly determines the reason why the heat dissipation status is abnormal, and effectively maintains the device.

With reference to the first aspect and the foregoing implementations of the first aspect, in another implementation of the first aspect, the method further includes: sending first alarm information to a network management server, where the first alarm information includes first information used to indicate that the heat dissipation status of the device is abnormal and/or second information used to indicate the reason why the heat dissipation status is abnormal.

With reference to the first aspect and the foregoing implementations of the first aspect, in another implementation of the first aspect, the method further includes: displaying second alarm information, where the second alarm information includes third information used to indicate that the heat dissipation status of the device is abnormal and/or fourth information used to indicate the reason why the heat dissipation status is abnormal.

With reference to the first aspect and the foregoing implementations of the first aspect, in another implementation of the first aspect, when it is determined that the heat dissipation status of the device is abnormal, the method further includes: making an alarm sound indicating that the heat dissipation status is abnormal.

According to a second aspect, an electronic device is provided, and includes a first barometer, a second barometer, and a processor, where the first barometer is disposed on an external surface of the device, and the second barometer is disposed inside the device; the first barometer is configured to obtain first atmospheric pressure on the external surface of the device; the second barometer is configured to obtain second atmospheric pressure inside the device; and the processor is configured to determine, based on a difference between the second atmospheric pressure and the first atmospheric pressure, whether a heat dissipation status of the device is normal.

Units of the device in the second aspect and functions of the units may be corresponding to the method for monitoring the heat dissipation status of the device according to the first aspect, and each unit of the device may implement a corresponding procedure of the method. For brevity, details are not described herein again.

According to a third aspect not covered by the claims, an apparatus for monitoring a heat dissipation status of a device is provided, including: a first barometer, configured to obtain first atmospheric pressure on an external surface of the device; a second barometer, configured to obtain second atmospheric pressure inside the device; and a processor, configured to determine, based on a difference between the second atmospheric pressure and the first atmospheric pressure, whether the heat dissipation status of the device is normal.

Units of the apparatus in the third aspect and functions of the units may be corresponding to the method for monitoring the heat dissipation status of the device according to the first aspect, and each unit of the apparatus may implement a corresponding procedure of the method. For brevity, details are not described herein again.

According to a fourth aspect not covered by the claims, a computer readable medium is provided, and is configured to store a computer program, where the computer program includes an instruction used to perform the method according to the first aspect or any possible implementation of the first aspect.

### BRIEF DESCRIPTION OF DRAWINGS

FIG 1a and FIG 1b are schematic diagrams of working modes of a heat dissipation fan according to an embodiment of this application;
FIG 2 is a schematic block diagram of a device according to an embodiment of this application;
FIG 3 is another schematic block diagram of a device according to an embodiment of this application;
FIG 4 is still another schematic block diagram of a device according to an embodiment of this application;
FIG 5 is a schematic block diagram of an apparatus according to an embodiment of this application;
FIG 6 is a schematic flowchart of a method for monitoring a heat dissipation status of a device according to an embodiment of this application; and
FIG 7 is another schematic flowchart of a method for monitoring a heat dissipation status of a device according to an embodiment of this application.

### DESCRIPTION OF EMBODIMENTS

The following clearly and completely describes the technical solutions in the embodiments of this application with reference to the accompanying drawings in the embodiments of this application.

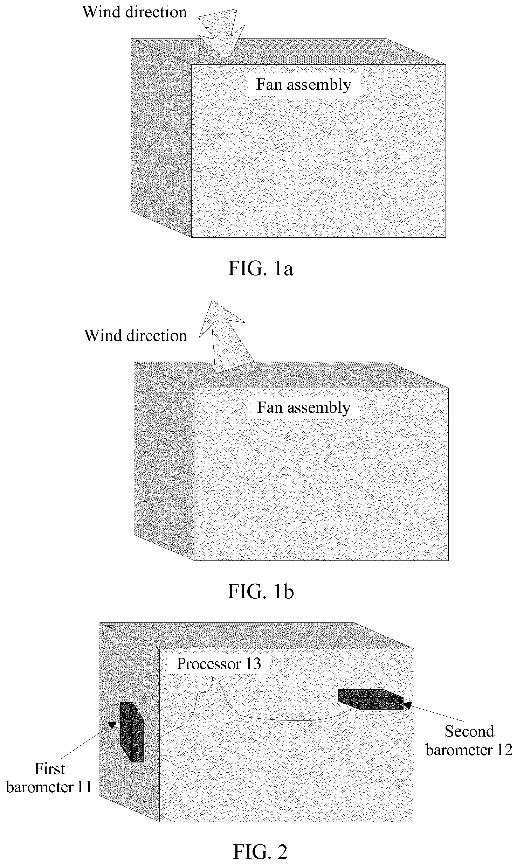

FIG 1a and FIG 1b are schematic diagrams of working modes of a heat dissipation fan according to an embodiment of this application. As shown in FIG 1a, the heat dissipation fan works in a blowing heat dissipation mode. In the blowing heat dissipation mode, the heat dissipation fan blows into an inside of a device to generate a turbulent flow inside the device, to dissipate heat. As shown in FIG 1b, the heat dissipation fan dissipates heat through blowing. In the suction heat dissipation mode, the heat dissipation fan sucks out hot air inside a device to generate a laminar flow inside the device, to dissipate heat.

Usually, a heat dissipation status of the device is abnormal because the heat dissipation fan is faulty or an air duct is blocked. In the prior art, whether a heat dissipation fan stops running is detected to determine whether a heat dissipation status of a device is normal. In the solution in the prior art, when the heat dissipation fan normally runs but an air duct is blocked, it is still considered that the heat dissipation status of the device is normal. Consequently, the device works abnormally, and the device burns up in a worse case. Therefore, a device, an apparatus, and a method for monitoring a heat dissipation status of the device need to be provided, to effectively monitor the heat dissipation status of the device, and avoid the foregoing problem in the prior art.

FIG 2 shows a device 10 according to an embodiment of this application. As shown in FIG 2, the device 10 includes a first barometer 11, a second barometer 12, and a processor 13. The first barometer 11 is disposed on an external surface of the device, and the second barometer 12 is disposed inside the device.

The first barometer 11 is configured to obtain first atmospheric pressure on the external surface of the device.

The second barometer 12 is configured to obtain second atmospheric pressure inside the device. The processor 13 is configured to determine, based on a difference between the second atmospheric pressure and the first atmospheric pressure, whether a heat dissipation status of the device is normal.

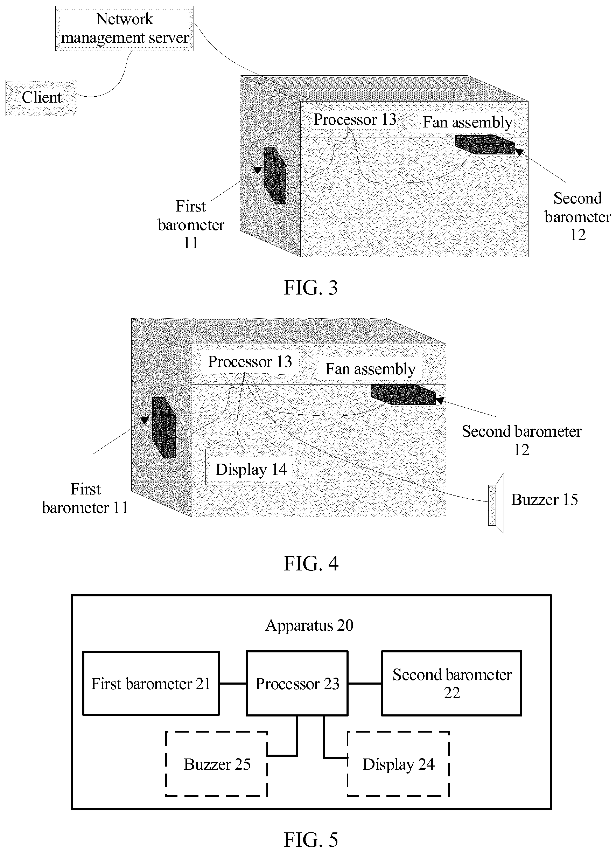

Specifically, according to the invention, as shown in FIG 3, the first barometer 11 is disposed on the external surface of the device. For example, the first barometer 11 is disposed on an outside of a backplane of the device or outside an air duct of the device. A power supply on the backplane of the device supplies power to the first barometer 11. Inside the device, according to the invention, the second barometer 12 is disposed and may be positioned on an air outlet surface of a fan assembly of a heat dissipation fan, and a power supply on the fan assembly supplies power to the second barometer 12. The first barometer 11 and the second barometer 12 are connected to the processor 13. The processor 13 is a central processing unit (Central Processing Unit, "CPU" for short) on the fan assembly or a CPU on a main control board of the device, and the processor 13 controls the first barometer 11 and the second barometer 12 to respectively obtain the first atmospheric pressure and the second atmospheric pressure. The processor 13 subtracts the collected first atmospheric pressure from the collected second atmospheric pressure, and determines, based on the difference, whether the heat dissipation status of the device is normal.

It may be understood that when the heat dissipation fan works in a blowing heat dissipation mode and a heat dissipation fault occurs on the device, atmospheric pressure inside the device decreases; and when the heat dissipation fan dissipates heat through blowing and a heat dissipation fault occurs on the device, atmospheric pressure inside the device increases.

In this way, the processor 13 determines, based on the difference between the second atmospheric pressure and the first atmospheric pressure, whether the heat dissipation status of the device is normal. If the heat dissipation fan works in the blowing heat dissipation mode and the difference between the second atmospheric pressure and the first atmospheric pressure is less than or equal to a first preset threshold, the processor 13 determines that the heat dissipation status of the device is abnormal. Correspondingly, when the difference between the second atmospheric pressure and the first atmospheric pressure is greater than the first preset threshold, the processor 13 determines that the heat dissipation status of the device is normal. Alternatively, if the heat dissipation fan works in the suction heat dissipation mode, and the difference between the second atmospheric pressure and the first atmospheric pressure is less than a second preset threshold, the processor 13 determines that the heat dissipation status of the device is normal. Correspondingly, when the difference between the second atmospheric pressure and the first atmospheric pressure is greater than or equal to a second preset threshold, the processor 13 determines that the heat dissipation status of the device is abnormal.

In addition, the first preset threshold and the second preset threshold may be any proper value specified based on experience.

In the foregoing embodiment, according to the invention, the first barometer 11 and the second barometer 12 are connected to the CPU on the fan assembly or the CPU on the main control board of the device by using an inter-integrated circuit (Inter-integrated Circuit, "IIC" for short) bus (BUS) or a serial peripheral interface (serial peripheral interface, "SPI" for short) bus, to exchange data. For example, the CPU on the fan assembly or the CPU on the main control board of the device polls, in real time, an atmospheric pressure value measured by the first barometer 11 and an atmospheric pressure value measured by the second barometer 12.

In this embodiment of this application, optionally, when the processor 13 determines that the heat dissipation status of the device is abnormal, the processor 13 may further determine a reason why the heat dissipation status of the device is abnormal.

Specifically, the processor 13 obtains a rotational speed of the heat dissipation fan, and determines, based on a value relationship between the rotational speed of the heat dissipation fan and a preset rotational speed, the reason why the heat dissipation status of the device is abnormal. If the processor 13 determines that the rotational speed of the heat dissipation fan is 0 or is less than the preset rotational speed, the processor 13 determines that the heat dissipation status of the device is abnormal because the heat dissipation fan is faulty. If the processor 13 determines that the rotational speed of the heat dissipation fan is equal to the preset rotational speed, the processor 13 determines that the heat dissipation status of the device is abnormal because the air duct is blocked.

Further, as shown in FIG 3, the device may communicate with a network management server, and the network management server communicates with a client. In this way, when the processor 13 determines that the heat dissipation status of the device is abnormal, the processor 13 may actively report an abnormal alarm.

Specifically, the processor 13 communicates with the network management server by using the Transmission Control Protocol (Transmission Control Protocol, "TCP" for short), and the processor 13 uploads abnormal alarm information to the network management server by using a management channel. The abnormal alarm information may include information used to indicate that the heat dissipation status of the device is abnormal and/or information used to indicate the reason why the heat dissipation status is abnormal.

Further, the network management server is connected to the client by using the TCP, the network management server actively pushes, to the client, the abnormal alarm information reported by the processor 13, and a maintenance engineer obtains the abnormal alarm information from the client.

Optionally, the processor 13 reports the first atmospheric pressure and the second atmospheric pressure to the network management server, and the maintenance engineer may actively query the first atmospheric pressure and the second atmospheric pressure by using the network management server, to remotely monitor a status of the device.

Alternatively, as shown in FIG 4, the device is an independently used instrument/meter device, and the device does not communicate with a network management server. In this case, the processor may control a display 14 of the device to display alarm information. For example, "the heat dissipation status of the device is abnormal", "the heat dissipation fan of the device is faulty", or "the air duct of the device is blocked" is displayed. A user determines, based on the information displayed on the display, that the heat dissipation status of the device is abnormal, and determines the reason why the heat dissipation status of the device is abnormal.

Further, as shown in FIG 4, the device further includes a buzzer 15. When determining that the heat dissipation status of the device is abnormal, the processor 13 controls the buzzer 15 to make an alarm sound indicating that the heat dissipation status is abnormal, and the user determines, based on the alarm sound, that the heat dissipation status of the device is abnormal.

The device for monitoring the heat dissipation status of the device according to the embodiments of this application is described in detail above with reference to FIG 1 to FIG 4. An apparatus 20 for monitoring a heat dissipation status of a device according to an embodiment of this application is described in detail below with reference to FIG 5. As shown in FIG 5, the apparatus 20 includes:
a first barometer 21, configured to obtain first atmospheric pressure on an external surface of the device;
a second barometer 22, configured to obtain second atmospheric pressure inside the device; and
a processor 23, configured to determine, based on a difference between the second atmospheric pressure and the first atmospheric pressure, whether the heat dissipation status of the device is normal.

It should be noted that the apparatus 20 is an apparatus independent of the monitored device.

Therefore, the apparatus for monitoring the heat dissipation status of the device in this embodiment of this application determines, based on a difference between atmospheric pressure on the external surface of the device and atmospheric pressure inside the device, whether the heat dissipation status of the device is normal. In this way, the heat dissipation status of the device can be effectively monitored.

In this embodiment of this application, a heat dissipation fan is disposed inside the device, the heat dissipation fan has a fan assembly, and the second barometer 22 is specifically configured to obtain second atmospheric pressure on an air outlet surface of the fan assembly.

In this embodiment of this application, the heat dissipation fan works in a blowing heat dissipation mode.

The processor 23 is specifically configured to: when determining that the difference between the second atmospheric pressure and the first atmospheric pressure is greater than a first preset threshold, determine that the heat dissipation status of the device is normal; or when determining that the difference between the second atmospheric pressure and the first atmospheric pressure is less than or equal to a first preset threshold, determine that the heat dissipation status of the device is abnormal.

In this embodiment of this application, the heat dissipation fan dissipates heat through blowing.

The processor 23 is specifically configured to: when determining that the difference between the second atmospheric pressure and the first atmospheric pressure is less than a second preset threshold, determine that the heat dissipation status of the device is normal; or when determining that the difference between the second atmospheric pressure and the first atmospheric pressure is greater than or equal to a second preset threshold, determine that the heat dissipation status of the device is abnormal.

In this embodiment of this application, optionally, when the processor 23 determines that the heat dissipation status of the device is abnormal, the processor 23 is further configured to: obtain a rotational speed of the heat dissipation fan; and determine, based on a value relationship between the rotational speed of the heat dissipation fan and a preset rotational speed, a reason why the heat dissipation status of the device is abnormal.

In this embodiment of this application, optionally, the processor 23 is specifically configured to: when determining that the rotational speed of the heat dissipation fan is less than the preset rotational speed, determine that the heat dissipation status of the device is abnormal because the heat dissipation fan is faulty; or when determining that the rotational speed of the heat dissipation fan is equal to the preset rotational speed, determine that the heat dissipation status of the device is abnormal because an air duct is blocked.

In this embodiment of this application, optionally, the processor 23 is further configured to send first alarm information to a network management server. The first alarm information includes first information used to indicate that the heat dissipation status of the device is abnormal and/or second information used to indicate the reason why the heat dissipation status is abnormal.

In this embodiment of this application, optionally, as shown in FIG 5, the apparatus further includes a display 24, and the processor 23 is further configured to control the display 24 to display second alarm information. The second alarm information includes third information used to indicate that the heat dissipation status of the device is abnormal and/or fourth information used to indicate the reason why the heat dissipation status is abnormal.

In this embodiment of this application, optionally, as shown in FIG 5, the apparatus further includes a buzzer 25, and the processor 23 is further configured to control the buzzer 25 to make an alarm sound indicating that the heat dissipation status is abnormal.

A person skilled in the art may understand that a specific function of each unit in the apparatus 20 is the same as a function of a corresponding unit in the device 10. To avoid repetition, details are not described herein again.

Optionally, in an embodiment, the apparatus 20 may further include a memory. The memory is configured to store a computer program, and the computer program includes an instruction used to perform a method for monitoring the heat dissipation status of the device.

It may be understood that the processor in the embodiments of this application may be an integrated circuit chip, and has a signal processing capability. The processor may be a general purpose processor, a digital signal processor (Digital Signal Processor, DSP), an application-specific integrated circuit (Application-Specific Integrated Circuit, ASIC), a field programmable gate array (Field Programmable Gate Array, FPGA) or another programmable logical device, a discrete gate or a transistor logic device, or a discrete hardware component. The processor may implement or perform the methods, steps, and logical block diagrams that are disclosed in the embodiments of this application. The general purpose processor may be a microprocessor, or the processor may be any conventional processor, or the like.

The memory in the embodiments of this application may be a volatile memory or a nonvolatile memory, or may include a volatile memory and a nonvolatile memory. The nonvolatile memory may be a read-only memory (Read-Only Memory, ROM), a programmable read-only memory (Programmable ROM, PROM), an erasable programmable read only memory (Erasable PROM, EPROM), an electrically erasable programmable read only memory (Electrically EPROM, EEPROM), or a flash memory. The volatile memory may be a random access memory (Random Access Memory, RAM), and is used as an external cache. For example but not for limitation, many forms of RAMs are available, for example, a static random access memory (Static RAM, SRAM), a dynamic random access memory (Dynamic RAM, DRAM), a synchronous dynamic random access memory (Synchronous DRAM, SDRAM), a double data rate synchronous dynamic random access memory (Double Data Rate SDRAM, DDR SDRAM), an enhanced synchronous dynamic random access memory (Enhanced SDRAM, ESDRAM), a synchronous link dynamic random access memory (Synchlink DRAM, SLDRAM), and a direct rambus dynamic random access memory (Direct Rambus RAM, DR RAM). It should be noted that the memory of the systems and methods described in this specification includes but is not limited to these and any memory of another proper type.

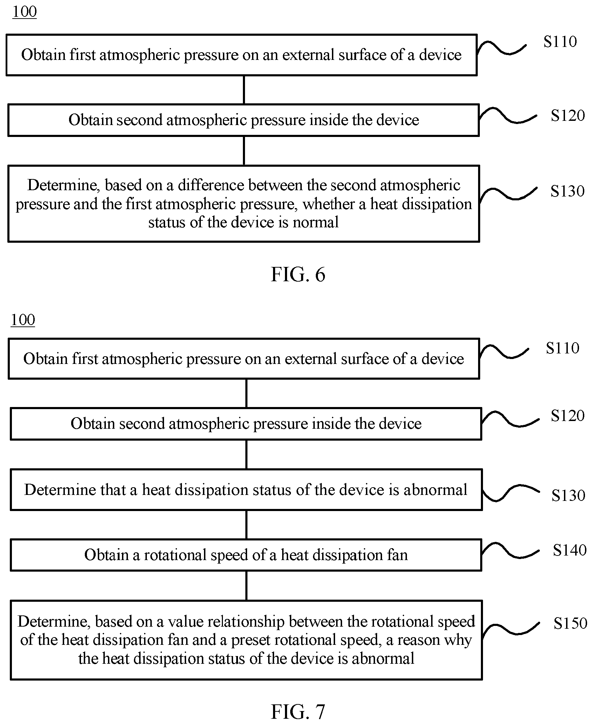

The foregoing device 10 or apparatus 20 performs the following method 100 for monitoring a heat dissipation status of a device. As shown in FIG 6, the method 100 includes the following steps:
S 110. Obtain first atmospheric pressure on an external surface of the device.
S 120. Obtain second atmospheric pressure inside the device.
S130. Determine, based on a difference between the second atmospheric pressure and the first atmospheric pressure, whether a heat dissipation status of the device is normal.

Therefore, according to the method for monitoring the heat dissipation status of the device in this embodiment of this application, whether the heat dissipation status of the device is normal is determined based on a difference between atmospheric pressure on the external surface of the device and atmospheric pressure inside the device. In this way, the heat dissipation status of the device can be effectively monitored.

In this embodiment of this application, a heat dissipation fan is disposed inside the device, and the heat dissipation fan has a fan assembly.

S120 is specifically: Obtain second atmospheric pressure on an air outlet surface of the fan assembly.

In this embodiment of this application, the heat dissipation fan works in a blowing heat dissipation mode.

S130 is specifically: When it is determined that the difference between the second atmospheric pressure and the first atmospheric pressure is greater than a first preset threshold, determine that the heat dissipation status of the device is normal; or when it is determined that the difference between the second atmospheric pressure and the first atmospheric pressure is less than or equal to a first preset threshold, determine that the heat dissipation status of the device is abnormal.

In this embodiment of this application, the heat dissipation fan dissipates heat through blowing.

S130 is specifically: When it is determined that the difference between the second atmospheric pressure and the first atmospheric pressure is less than a second preset threshold, determine that the heat dissipation status of the device is normal; or when it is determined that the difference between the second atmospheric pressure and the first atmospheric pressure is greater than or equal to a second preset threshold, determine that the heat dissipation status of the device is abnormal.

In this embodiment of this application, optionally, as shown in FIG 7, when it is determined that the heat dissipation status of the device is abnormal in S130, the method further includes the following steps:
S140. Obtain a rotational speed of a heat dissipation fan.
S150. Determine, based on a value relationship between the rotational speed of the heat dissipation fan and a preset rotational speed, a reason why the heat dissipation status of the device is abnormal.

In this embodiment of this application, optionally, S150 is specifically: When it is determined that the rotational speed of the heat dissipation fan is less than the preset rotational speed, determine that the heat dissipation status of the device is abnormal because the heat dissipation fan is faulty; or when it is determined that the rotational speed of the heat dissipation fan is equal to the preset rotational speed, determine that the heat dissipation status of the device is abnormal because an air duct is blocked.

In this embodiment of this application, optionally, the method further includes: sending first alarm information to a network management server, where the first alarm information includes first information used to indicate that the heat dissipation status of the device is abnormal and/or second information used to indicate the reason why the heat dissipation status is abnormal.

In this embodiment of this application, optionally, the method further includes: displaying second alarm information, where the second alarm information includes third information used to indicate that the heat dissipation status of the device is abnormal and/or fourth information used to indicate the reason why the heat dissipation status is abnormal.

In this embodiment of this application, optionally, when it is determined that the heat dissipation status of the device is abnormal, the method further includes: making an alarm sound indicating that the heat dissipation status is abnormal.

Therefore, according to the method for monitoring the heat dissipation status of the device in this embodiment of this application, whether the heat dissipation status of the device is normal is determined based on a difference between atmospheric pressure on the external surface of the device and atmospheric pressure inside the device. In this way, the heat dissipation status of the device can be effectively monitored.

A person of ordinary skill in the art may be aware that, the example units and algorithm steps described in the embodiments disclosed in this specification can be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments. Details are not described herein again.

In the several embodiments provided in this application, it should be understood that the disclosed system, apparatus, and method may be implemented in other manners. For example, the described apparatus embodiment is merely an example. For example, the unit division is merely logical function division and may be other division in actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of the embodiments.

In addition, functional units in the embodiments of this application may be integrated into one processing unit, or each of the units may exist alone physically, or two or more units are integrated into one unit.

When the functions are implemented in a form of a software functional unit and sold or used as an independent product, the functions may be stored in a computer readable storage medium. Based on such an understanding, the technical solutions of this application essentially, or the part contributing to the prior art, or some of the technical solutions may be implemented in a form of a software product. The computer software product is stored in a storage medium, and includes several instructions for instructing a computer device (which may be a personal computer, a server, or a network device) to perform all or some of the steps of the methods described in the embodiments of this application. The foregoing storage medium includes any medium that can store program code, such as a USB flash drive, a removable hard disk, a read-only memory (ROM, Read-Only Memory), a random access memory (RAM, Random Access Memory), a magnetic disk, or an optical disc.

The foregoing descriptions are merely specific implementations of this application, but this application is not limited thereto.

## Claims

1. An electronic device (20), comprising a first barometer (11, 21), a second barometer (12, 22), a heat dissipation fan and a processor (13, 23), wherein the first barometer (11, 21) is disposed on an external surface of the electronic device (20), and the second barometer (12, 22) is disposed inside the electronic device (20);
the first barometer (11, 21) is configured to obtain a first atmospheric pressure on the external surface of the electronic device (20);
the second barometer (12, 22) is configured to obtain a second atmospheric pressure inside the electronic device (20); the first barometer (11, 21) and the second barometer (12, 22) are connected to the processor (13, 23) by using an inter-integrated circuit bus or a serial peripheral interface bus, and
the processor (13, 23) is a central processing unit, CPU, on a fan assembly or on a main control board in the electronic device (20), the processor (13, 23) is configured to determine, based on a difference between the second atmospheric pressure and the first atmospheric pressure, whether a heat dissipation status of the electronic device (20) is normal,
wherein the heat dissipation fan is disposed inside the electronic device (20), the heat dissipation fan has the fan assembly,
when the heat dissipation fan works in a blowing heat dissipation mode: when it is determined that the difference between the second atmospheric pressure and the first atmospheric pressure is greater than a first preset threshold, determining that the heat dissipation status of the electronic device (20) is normal; or when it is determined that the difference between the second atmospheric pressure and the first atmospheric pressure is less than or equal to the first preset threshold, determining that the heat dissipation status of the electronic device (20) is abnormal;
when the heat dissipation fan dissipates heat through suction: when it is determined that the difference between the second atmospheric pressure and the first atmospheric pressure is less than a second preset threshold, determining that the heat dissipation status of the electronic device (20) is normal; or when it is determined that the difference between the second atmospheric pressure and the first atmospheric pressure is greater than or equal to the second preset threshold, determining that the heat dissipation status of the electronic device (20) is abnormal.

2. The electronic device (20) according to claim 1, wherein when the processor (13, 23) determines that the heat dissipation status of the electronic device (20) is abnormal, the processor (13, 23) is further configured to:
obtain a rotational speed of the heat dissipation fan; and
determine, based on a value relationship between the rotational speed of the heat dissipation fan and a preset rotational speed, a reason why the heat dissipation status of the electronic device (20) is abnormal.

3. The electronic device (20) according to claim 2, wherein the processor (13, 23) is configured to:
when determining that the rotational speed of the heat dissipation fan is less than the preset rotational speed, determine that the heat dissipation status of the electronic device (20) is abnormal because the heat dissipation fan is faulty; or when determining that the rotational speed of the heat dissipation fan is equal to the preset rotational speed, determine that the heat dissipation status of the electronic device (20) is abnormal because an air duct is blocked.

4. The electronic device (20) according to any one of claims 1 to 3, wherein the electronic device (20) further comprises a buzzer (15, 25), and the processor (13, 23) is further configured to:
control the buzzer (15, 25) to make an alarm sound indicating that the heat dissipation status is abnormal.

5. A method for monitoring a heat dissipation status of an electronic device (20), wherein the electronic device (20) includes a first barometer (11, 21), a second barometer (12, 22), a heat dissipation fan and a processor (13, 23), wherein the first barometer (11, 21) is disposed on an external surface of the electronic device (20), and the second barometer (12, 22) is disposed inside the electronic device (20), the method comprises:
obtaining (5110), by the first barometer (11, 21), a first atmospheric pressure on the external surface of the electronic device (20);
obtaining (S120), by the second barometer (12, 22), a second atmospheric pressure inside the electronic device (20); and
determining (S130), by the processor (13, 23), based on a difference between the second atmospheric pressure and the first atmospheric pressure, whether the heat dissipation status of the electronic device (20) is normal, wherein the first barometer (11, 21) and the second barometer (12, 22) are connected to the processor (13, 23) by using an inter-integrated circuit bus or a serial peripheral interface bus,
wherein the heat dissipation fan is disposed inside the electronic device (20), the heat dissipation fan has the fan assembly,
when the heat dissipation fan works in a blowing heat dissipation mode: when it is determined that the difference between the second atmospheric pressure and the first atmospheric pressure is greater than a first preset threshold, determining that the heat dissipation status of the electronic device (20) is normal; or when it is determined that the difference between the second atmospheric pressure and the first atmospheric pressure is less than or equal to the first preset threshold, determining that the heat dissipation status of the electronic device (20) is abnormal;
when the heat dissipation fan dissipates heat through suction: when it is determined that the difference between the second atmospheric pressure and the first atmospheric pressure is less than a second preset threshold, determining that the heat dissipation status of the electronic device (20) is normal; or when it is determined that the difference between the second atmospheric pressure and the first atmospheric pressure is greater than or equal to the second preset threshold, determining that the heat dissipation status of the electronic device (20) is abnormal.

6. The method according to claim 5, wherein when it is determined that the heat dissipation status of the electronic device (20) is abnormal, the method further comprises:
obtaining (S140) a rotational speed of the heat dissipation fan; and
determining (S 150), based on a value relationship between the rotational speed of the heat dissipation fan and a preset rotational speed, a reason why the heat dissipation status of the device is abnormal.

7. The method according to claim 6, wherein the determining (S150), based on the value relationship between the rotational speed of the heat dissipation fan and the preset rotational speed, the reason why the heat dissipation status of the device is abnormal comprises:
when it is determined that the rotational speed of the heat dissipation fan is less than the preset rotational speed, determining that the heat dissipation status of the electronic device (20) is abnormal because the heat dissipation fan is faulty; or when it is determined that the rotational speed of the heat dissipation fan is equal to the preset rotational speed, determining that the heat dissipation status of the device is abnormal because an air duct is blocked.

8. The method according to any one of claims 5 to 7, wherein when it is determined that the heat dissipation status of the electric device (20) is abnormal, the method further comprises:
making an alarm sound indicating that the heat dissipation status is abnormal.

## Patentansprüche

1. Elektronische Vorrichtung (20), die ein erstes Barometer (11, 21), ein zweites Barometer (12, 22), einen Wärmeableitungslüfter und einen Prozessor (13, 23) umfasst, wobei das erste Barometer (11, 21) auf einer Außenfläche der elektronischen Vorrichtung (20) angeordnet ist und das zweite Barometer (12, 22) innerhalb der elektronischen Vorrichtung (20) angeordnet ist;
das erste Barometer (11, 21) dazu konfiguriert ist, einen ersten atmosphärischen Druck auf der Außenfläche der elektronischen Vorrichtung (20) zu erhalten;
das zweite Barometer (12, 22) dazu konfiguriert ist, einen zweiten atmosphärischen Druck innerhalb der elektronischen Vorrichtung (20) zu erhalten; das erste Barometer (11, 21) und das zweite Barometer (12, 22) mit dem Prozessor (13, 23) unter Verwendung eines Inter-Integrated-Circuit-Bus oder eines seriellen Peripherieschnittstellenbus verbunden sind, und
der Prozessor (13, 23) eine zentrale Verarbeitungseinheit, CPU, auf einer Lüfterbaugruppe oder auf einer Hauptsteuerplatine in der elektronischen Vorrichtung (20) ist, der Prozessor (13, 23) dazu konfiguriert ist, basierend auf einer Differenz zwischen dem zweiten atmosphärischen Druck und dem ersten atmosphärischen Druck zu bestimmen, ob ein Wärmeableitzustand der elektronischen Vorrichtung (20) normal ist,
wobei der Wärmeableitungslüfter innerhalb der elektronischen Vorrichtung (20) angeordnet ist, der Wärmeableitungslüfter die Lüfterbaugruppe aufweist,
wenn der Wärmeableitungslüfter in einem Blas-Wärmeableitungsmodus arbeitet: wenn bestimmt wird, dass die Differenz zwischen dem zweiten atmosphärischen Druck und dem ersten atmosphärischen Druck größer als ein erster voreingestellter Schwellenwert ist, Bestimmen, dass der Wärmeableitzustand der elektronischen Vorrichtung (20) normal ist; oder wenn bestimmt wird, dass die Differenz zwischen dem zweiten atmosphärischen Druck und dem ersten atmosphärischen Druck kleiner oder gleich dem ersten voreingestellten Schwellenwert ist, Bestimmen, dass der Wärmeableitzustand der elektronischen Vorrichtung (20) abnormal ist;
wenn der Wärmeableitungslüfter Wärme durch Absaugung ableitet: wenn bestimmt wird, dass die Differenz zwischen dem zweiten atmosphärischen Druck und dem ersten atmosphärischen Druck kleiner als ein zweiter voreingestellter Schwellenwert ist, Bestimmen, dass der Wärmeableitzustand der elektronischen Vorrichtung (20) normal ist; oder wenn bestimmt wird, dass die Differenz zwischen dem zweiten atmosphärischen Druck und dem ersten atmosphärischen Druck größer oder gleich dem zweiten voreingestellten Schwellenwert ist, Bestimmen, dass der Wärmeableitzustand der elektronischen Vorrichtung (20) abnormal ist.

2. Elektronische Vorrichtung (20) nach Anspruch 1, wobei, wenn der Prozessor (13, 23) bestimmt, dass der Wärmeableitzustand der elektronischen Vorrichtung (20) abnormal ist, der Prozessor (13, 23) ferner zu Folgendem konfiguriert ist:
Erhalten einer Drehzahl des Wärmeableitungslüfters; und
Bestimmen, basierend auf einem Werteverhältnis zwischen der Drehzahl des Wärmeableitungslüfters und einer voreingestellten Drehzahl, eines Grunds, warum der Wärmeableitzustand der elektronischen Vorrichtung (20) abnormal ist.

3. Elektronische Vorrichtung (20) nach Anspruch 2, wobei der Prozessor (13, 23) zu Folgendem konfiguriert ist:
wenn bestimmt wird, dass die Drehzahl des Wärmeableitungslüfters kleiner als die voreingestellte Drehzahl ist, Bestimmen, dass der Wärmeableitzustand der elektronischen Vorrichtung (20) abnormal ist, weil der Wärmeableitungslüfter fehlerhaft ist; oder wenn bestimmt wird, dass die Drehzahl des Wärmeableitungslüfters gleich der voreingestellten Drehzahl ist, Bestimmen, dass der Wärmeableitzustand der elektronischen Vorrichtung (20) abnormal ist, weil ein Luftkanal blockiert ist.

4. Elektronische Vorrichtung (20) nach einem der Ansprüche 1 bis 3, wobei die elektronische Vorrichtung (20) ferner einen Summer (15, 25) umfasst und der Prozessor (13, 23) ferner zu Folgendem konfiguriert ist:
Steuern des Summers (15, 25), um einen Alarmton auszulösen, der anzeigt, dass der Wärmeableitzustand abnormal ist.

5. Verfahren zum Überwachen eines Wärmeableitzustands einer elektronischen Vorrichtung (20), wobei die elektronische Vorrichtung (20) ein erstes Barometer (11, 21), ein zweites Barometer (12, 22), einen Wärmeableitungslüfter und einen Prozessor (13, 23) beinhaltet, wobei das erste Barometer (11, 21) auf einer Außenfläche der elektronischen Vorrichtung (20) angeordnet ist und das zweite Barometer (12, 22) innerhalb der elektronischen Vorrichtung (20) angeordnet ist, wobei das Verfahren Folgendes umfasst:
Erhalten (S110), durch das erste Barometer (11, 21), eines ersten atmosphärischen Drucks auf der Außenfläche der elektronischen Vorrichtung (20);
Erhalten (S120), durch das zweite Barometer (12, 22), eines zweiten atmosphärischen Drucks innerhalb der elektronischen Vorrichtung (20) ; und
Bestimmen (S130), durch den Prozessor (13, 23), basierend auf einer Differenz zwischen dem zweiten atmosphärischen Druck und dem ersten atmosphärischen Druck, ob der Wärmeableitzustand der elektronischen Vorrichtung (20) normal ist, wobei das erste Barometer (11, 21) und das zweite Barometer (12, 22) mit dem Prozessor (13, 23) unter Verwendung eines Inter-Integrated-Circuit-Bus oder eines seriellen Peripherieschnittstellenbus verbunden sind,
wobei der Wärmeableitungslüfter innerhalb der elektronischen Vorrichtung (20) angeordnet ist, der Wärmeableitungslüfter die Lüfterbaugruppe aufweist,
wenn der Wärmeableitungslüfter in einem Blas-Wärmeableitungsmodus arbeitet: wenn bestimmt wird, dass die Differenz zwischen dem zweiten atmosphärischen Druck und dem ersten atmosphärischen Druck größer als ein erster voreingestellter Schwellenwert ist, Bestimmen, dass der Wärmeableitzustand der elektronischen Vorrichtung (20) normal ist; oder wenn bestimmt wird, dass die Differenz zwischen dem zweiten atmosphärischen Druck und dem ersten atmosphärischen Druck kleiner oder gleich dem ersten voreingestellten Schwellenwert ist, Bestimmen, dass der Wärmeableitzustand der elektronischen Vorrichtung (20) abnormal ist;
wenn der Wärmeableitungslüfter Wärme durch Absaugung ableitet: wenn bestimmt wird, dass die Differenz zwischen dem zweiten atmosphärischen Druck und dem ersten atmosphärischen Druck kleiner als ein zweiter voreingestellter Schwellenwert ist, Bestimmen, dass der Wärmeableitzustand der elektronischen Vorrichtung (20) normal ist; oder wenn bestimmt wird, dass die Differenz zwischen dem zweiten atmosphärischen Druck und dem ersten atmosphärischen Druck größer oder gleich dem zweiten voreingestellten Schwellenwert ist, Bestimmen, dass der Wärmeableitzustand der elektronischen Vorrichtung (20) abnormal ist.

6. Verfahren nach Anspruch 5, wobei, wenn bestimmt wird, dass der Wärmeableitzustand der elektronischen Vorrichtung (20) abnormal ist, das Verfahren ferner Folgendes umfasst:
Erhalten (S140) einer Drehzahl des Wärmeableitungslüfters; und
Bestimmen (S150), basierend auf einem Werteverhältnis zwischen der Drehzahl des Wärmeableitungslüfters und einer voreingestellten Drehzahl, eines Grunds, warum der Wärmeableitzustand der Vorrichtung abnormal ist.

7. Verfahren nach Anspruch 6, wobei das Bestimmen (S150), basierend auf dem Werteverhältnis zwischen der Drehzahl des Wärmeableitungslüfters und der voreingestellten Drehzahl, des Grunds, warum der Wärmeableitzustand der Vorrichtung abnormal ist, Folgendes umfasst:
wenn bestimmt wird, dass die Drehzahl des Wärmeableitungslüfters kleiner als die voreingestellte Drehzahl ist, Bestimmen, dass der Wärmeableitzustand der elektronischen Vorrichtung (20) abnormal ist, weil der Wärmeableitungslüfter fehlerhaft ist; oder wenn bestimmt wird, dass die Drehzahl des Wärmeableitungslüfters gleich der voreingestellten Drehzahl ist, Bestimmen, dass der Wärmeableitzustand der Vorrichtung abnormal ist, weil ein Luftkanal blockiert ist.

8. Verfahren nach einem der Ansprüche 5 bis 7, wobei, wenn bestimmt wird, dass der Wärmeableitzustand der elektrischen Vorrichtung (20) abnormal ist, das Verfahren ferner Folgendes umfasst:
Auslösen eines Alarmtons, der anzeigt, dass der Wärmeableitzustand abnormal ist.

## Revendications

1. Dispositif électronique (20), comprenant un premier baromètre (11, 21), un second baromètre (12, 22), un ventilateur de dissipation thermique et un processeur (13, 23), dans lequel le premier baromètre (11, 21) est disposé sur une surface externe du dispositif électronique (20), et le second baromètre (12, 22) est disposé à l'intérieur du dispositif électronique (20) ;
le premier baromètre (11, 21) est configuré pour obtenir une première pression atmosphérique sur la surface externe du dispositif électronique (20) ;
le second baromètre (12, 22) est configuré pour obtenir une seconde pression atmosphérique à l'intérieur du dispositif électronique (20) ; le premier baromètre (11, 21) et le second baromètre (12, 22) sont connectés au processeur (13, 23) à l'aide d'un bus de circuit inter-intégré ou d'un bus d'interface périphérique série, et
le processeur (13, 23) est une unité centrale de traitement, CPU, sur un ensemble ventilateur ou sur une carte de commande principale dans le dispositif électronique (20), le processeur (13, 23) est configuré pour déterminer, sur la base d'une différence entre la seconde pression atmosphérique et la première pression atmosphérique, la question de savoir si un état de dissipation thermique du dispositif électronique (20) est normal,
dans lequel le ventilateur de dissipation thermique est disposé à l'intérieur du dispositif électronique (20), le ventilateur de dissipation thermique comprend l'ensemble ventilateur,
lorsque le ventilateur de dissipation thermique fonctionne dans un mode de dissipation thermique par soufflage : lorsqu'il est déterminé que la différence entre la seconde pression atmosphérique et la première pression atmosphérique est supérieure à un premier seuil prédéfini, la détermination que l'état de dissipation thermique du dispositif électronique (20) est normal ; ou lorsqu'il est déterminé que la différence entre la seconde pression atmosphérique et la première pression atmosphérique est inférieure ou égale au premier seuil prédéfini, la détermination que l'état de dissipation thermique du dispositif électronique (20) est anormal ;
lorsque le ventilateur de dissipation thermique dissipe la chaleur par aspiration : lorsqu'il est déterminé que la différence entre la seconde pression atmosphérique et la première pression atmosphérique est inférieure à un second seuil prédéfini, la détermination que l'état de dissipation thermique du dispositif électronique (20) est normal ; ou lorsqu'il est déterminé que la différence entre la seconde pression atmosphérique et la première pression atmosphérique est supérieure ou égale au second seuil prédéfini, la détermination que l'état de dissipation thermique du dispositif électronique (20) est anormal.

2. Dispositif électronique (20) selon la revendication 1, dans lequel lorsque le processeur (13, 23) détermine que l'état de dissipation thermique du dispositif électronique (20) est anormal, le processeur (13, 23) est en outre configuré pour :
obtenir une vitesse de rotation du ventilateur de dissipation thermique ; et
déterminer, sur la base d'une relation de valeur entre la vitesse de rotation du ventilateur de dissipation thermique et une vitesse de rotation prédéfinie, une raison pour laquelle l'état de dissipation thermique du dispositif électronique (20) est anormal.

3. Dispositif électronique (20) selon la revendication 2, dans lequel le processeur (13, 23) est configuré pour :
lors de la détermination que la vitesse de rotation du ventilateur de dissipation thermique est inférieure à la vitesse de rotation prédéfinie, déterminer que l'état de dissipation thermique du dispositif électronique (20) est anormal car le ventilateur de dissipation thermique est défectueux ; ou lors de la détermination que la vitesse de rotation du ventilateur de dissipation thermique est égale à la vitesse de rotation prédéfinie, déterminer que l'état de dissipation thermique du dispositif électronique (20) est anormal car un conduit d'air est bloqué.

4. Dispositif électronique (20) selon l'une quelconque des revendications 1 à 3, dans lequel le dispositif électronique (20) comprend également un buzzer (15, 25), et le processeur (13, 23) est en outre configuré pour :
commander le buzzer (15, 25) pour émettre un son d'alarme indiquant que l'état de dissipation thermique est anormal.

5. Procédé de surveillance d'un état de dissipation thermique d'un dispositif électronique (20), dans lequel le dispositif électronique (20) comprend un premier baromètre (11, 21), un second baromètre (12, 22), un ventilateur de dissipation thermique et un processeur (13, 23), dans lequel le premier baromètre (11, 21) est disposé sur une surface externe du dispositif électronique (20), et le second baromètre (12, 22) est disposé à l'intérieur du dispositif électronique (20), le procédé comprend :
l'obtention (S110), par le premier baromètre (11, 21), d'une première pression atmosphérique sur la surface externe du dispositif électronique (20) ;
l'obtention (S120), par le second baromètre (12, 22), d'une seconde pression atmosphérique à l'intérieur du dispositif électronique (20) ; et
la détermination (S130), par le processeur (13, 23), sur la base d'une différence entre la seconde pression atmosphérique et la première pression atmosphérique, de la question de savoir si l'état de dissipation thermique du dispositif électronique (20) est normal, dans lequel le premier baromètre (11 , 21) et le second baromètre (12, 22) sont connectés au processeur (13, 23) à l'aide d'un bus de circuit inter-intégré ou d'un bus d'interface périphérique série,
dans lequel le ventilateur de dissipation thermique est disposé à l'intérieur du dispositif électronique (20), le ventilateur de dissipation thermique comprend l'ensemble ventilateur,
lorsque le ventilateur de dissipation thermique fonctionne dans un mode de dissipation thermique par soufflage : lorsqu'il est déterminé que la différence entre la seconde pression atmosphérique et la première pression atmosphérique est supérieure à un premier seuil prédéfini, la détermination que l'état de dissipation thermique du dispositif électronique (20) est normal ; ou lorsqu'il est déterminé que la différence entre la seconde pression atmosphérique et la première pression atmosphérique est inférieure ou égale au premier seuil prédéfini, la détermination que l'état de dissipation thermique du dispositif électronique (20) est anormal ;
lorsque le ventilateur de dissipation thermique dissipe la chaleur par aspiration : lorsqu'il est déterminé que la différence entre la seconde pression atmosphérique et la première pression atmosphérique est inférieure à un second seuil prédéfini, la détermination que l'état de dissipation thermique du dispositif électronique (20) est normal ; ou lorsqu'il est déterminé que la différence entre la seconde pression atmosphérique et la première pression atmosphérique est supérieure ou égale au second seuil prédéfini, la détermination que l'état de dissipation thermique du dispositif électronique (20) est anormal.

6. Procédé selon la revendication 5, dans lequel lorsqu'il est déterminé que l'état de dissipation thermique du dispositif électronique (20) est anormal, le procédé comprend également :
l'obtention (S140) d'une vitesse de rotation du ventilateur de dissipation thermique ; et
la détermination (S150), sur la base d'une relation de valeur entre la vitesse de rotation du ventilateur de dissipation thermique et une vitesse de rotation prédéfinie, d'une raison pour laquelle l'état de dissipation thermique du dispositif est anormal.

7. Procédé selon la revendication 6, dans lequel la détermination (S150), sur la base d'une relation de valeur entre la vitesse de rotation du ventilateur de dissipation thermique et une vitesse de rotation prédéfinie, d'une raison pour laquelle l'état de dissipation thermique du dispositif est anormal, comprend :
lorsqu'il est déterminé que la vitesse de rotation du ventilateur de dissipation thermique est inférieure à la vitesse de rotation prédéfinie, la détermination que l'état de dissipation thermique du dispositif électronique (20) est anormal car le ventilateur de dissipation thermique est défectueux ; ou lorsqu'il est déterminé que la vitesse de rotation du ventilateur de dissipation thermique est égale à la vitesse de rotation prédéfinie, la détermination que l'état de dissipation thermique du dispositif est anormal car un conduit d'air est bloqué.

8. Procédé selon l'une quelconque des revendications 5 à 7, dans lequel lorsqu'il est déterminé que l'état de dissipation thermique du dispositif électrique (20) est anormal, le procédé comprend également :
l'émission d'une alarme sonore indiquant que l'état de dissipation thermique est anormal.
